# EUROPEAN PATENT SPECIFICATION

(11) **EP 2 894 515 B1**
(45) Date of publication and mention of the grant of the patent: **22.02.2017**
(21) Application number: 13831996.7
(22) Date of filing: 05.06.2013
(51) Int. Cl.: G03F 7/033, G03F 7/00, G03F 7/004, G03F 7/095, G03F 7/11, C08L 9/02, G03F 7/032

(54) **PHOTOSENSITIVE RESIN COMPOSITION FOR FLEXOGRAPHIC PRINTING ORIGINAL PLATE**
LICHTEMPFINDLICHE HARZZUSAMMENSETZUNG FÜR FLEXODRUCK-ORIGINALPLATTE
COMPOSITION DE RÉSINE PHOTOSENSIBLE POUR UNE PLAQUE ORIGINALE D'IMPRESSION FLEXOGRAPHIQUE

(30) Priority: 29.08.2012 JP 2012188298; 27.05.2013 JP 2013110791
(43) Date of publication of application: 15.07.2015
(73) Proprietor: Toyobo Co., Ltd., Osaka-shi Osaka 530-8230 (JP)
(72) Inventor: YAWATA, Yukimi, Okayama-shi, Okayama 704-8194 (JP); YAMADA, Hiroto, Okayama-shi, Okayama 704-8194 (JP)
(74) Representative: Müller-Boré & Partner Patentanwälte PartG mbB
(86) International application number: PCT/JP2013/065532
(87) International publication number: WO 2014/034213

(56) References cited:
- EP-A1- 0 967 523
- EP-A1- 1 757 981
- EP-A1- 2 295 258
- EP-A1- 2 363 748
- EP-A1- 2 461 215
- WO-A1-2004/090638
- WO-A1-2005/124461
- WO-A1-2012/086266
- WO-A1-2012/111238
- JP-A- 2000 155 417
- JP-A- 2003 287 887
- JP-A- 2004 170 597
- JP-A- 2004 170 597
- JP-A- 2004 295 120
- JP-A- 2005 010 252
- JP-A- 2005 062 711
- JP-A- 2005 257 727
- JP-A- 2009 298 104
- JP-A- 2011 203 453

## Description

### Technical Field of the Invention

The present invention relates to a photosensitive resin composition for a flexographic printing original plate which highly satisfies both printing durability and fine image reproducibility and is water-developable and also to a flexographic printing original plate prepared therefrom.

### Background Art

As a printing material for films, labels, envelopes, corrugated cardboards and paper bags, a flexographic printing plate has been used. In order to express flexibility of a flexographic printing plate, it mainly comprises an elastomer such as synthetic rubber, latex or styrene-butadiene block copolymer. There have been proposed many photosensitive resin compositions in which the above is compounded with a photopolymerizable compound and a photopolymerization initiator.

A flexographic printing original plate has a photosensitive layer comprising a photosensitive resin composition on a substrate. In such a flexographic printing original plate, negative film is closely attached onto a photosensitive layer, active ray is irradiated through the negative film and a resulting uncured part is removed whereupon a relief part is prepared. Recently, a flexographic printing original plate in which an aqueous developer is used for removing the uncured part has been put into the market.

With regard to a water-developable photosensitive resin composition, there is disclosed, for example, in Patent Document 1 a photosensitive resin composition containing at least two kinds of water-dispersible latexes, hydrophilic polymer, photopolymerizable compound and photopolymerization initiator. There are also disclosed, for example, in Patent Document 2 a photosensitive resin composition containing water-dispersible latex, photopolymerizable monomer, rubber and photopolymerization initiator and, in Patent Document 3, a photosensitive resin composition containing water-dispersible latex, rubber, surfactant, photopolymerizable monomer and photopolymerization initiator.

However, the photosensitive resin composition of Patent Document 1 has such a disadvantage that mechanical strength is insufficient and printing durability upon printing is insufficient. Each of the photosensitive resin compositions of Patent Documents 2 and 3 comprises one kind of water-dispersing latex and rubber whereby it has a disadvantage that its fine image reproducibility is inferior.

As such, the conventional water-developable photosensitive resin compositions satisfy only one of printing durability and fine image reproducibility.

### Prior Art Documents

### Patent Documents

Patent Document 1: WO 04/090638
Patent Document 2: Japanese Patent No. 4211141
Patent Document 3: WO 11/118052

EP-A-2295258, EP-A-0967523, JP-A-2009298104 describe a photosensitive resin composition for a flexographic printing original plate, said composition containing at least two kinds of water-dispersible latexes, a rubber, a photopolymerizable compound and a photopolymerization initiator.

### Disclosure of the Invention

### Problem that the Invention is to Solve

The present invention has been achieved for solving the problems as such in the conventional art and its object is to provide a water-developable photosensitive resin composition for flexographic printing original plate having a sufficient printing durability upon printing and also being very excellent in fine image reproducibility (1% reproducibility of 175 lpi) and also to provide a flexographic printing original plate prepared therefrom.

### Means for Solving the Problem

The present inventors have conducted extensive investigations for achieving the above object and found that, when hydrophobic polymers obtained from at least two kinds of water-dispersible latexes and a rubber are used in an appropriate rate, both printing durability and fine image reproducibility of a printing plate can be highly maintained whereupon they have achieved the present invention.

Thus, the present invention has the constitutions as shown in the following (1) to (6).
(1) A photosensitive resin composition for a flexographic printing original plate, characterized in that, the composition contains (A) hydrophobic polymers obtained from at least two kinds of water-dispersible latexes, (B) a rubber, (C) a photopolymerizable compound and (D) a photopolymerization initiator and that the ratio by mass of the component (B) to the total mass of the component (A) and the component (B) is within a range of 1 to 7%.
(2) The photosensitive resin composition for a flexographic printing original plate according to (1), wherein hydrophobic polymer(s) obtained from at least one kind of water-dispersible latex (es) in the above component (A) and the rubber of the component (B) have a common chemical structure unit.
(3) The photosensitive resin composition for a flexographic printing original plate according to (1) or (2), wherein it further contains (E) an aggregation inhibitor.
(4) A flexographic printing original plate, characterized in that, a layer comprising partially saponified polyvinyl acetate having a saponification degree of 60 to 99 molar % is formed on the surface of a photosensitive layer comprising the photosensitive resin composition mentioned in any of (1) to (3).
(5) A flexographic printing original plate, characterized in that, a layer comprising a water-soluble cellulose derivative is formed on the surface of a photosensitive layer comprising the photosensitive resin composition mentioned in any of (1) to (3).
(6) A flexographic printing original plate, characterized in that, an infrared ablation layer is formed on the surface of a photosensitive layer comprising the photosensitive resin composition mentioned in any of (1) to (3). Advantages of the Invention

In accordance with the photosensitive resin composition of the present invention, it is now possible to prepare a water-developable flexographic printing original plate in which both printing durability (mechanical strength and elongation) and fine image reproducibility (1% reproducibility of 175 lpi) are excellent.

### Best Mode for Carrying Out the Invention

Hereinafter, the present invention will be illustrated in detail. The flexographic printing original plate of the present invention is characterized in containing (A) hydrophobic polymers obtained from at least two kinds of water-dispersible latexes, (B) a rubber, (C) a photopolymerizable compound, (D) a photopolymerization initiator, and optionally (E) an aggregation inhibitor.

The component (A) (hydrophobic polymer obtained from water-dispersible latex) in the present invention is obtained from water-dispersible latex. The hydrophobic polymer obtained from water-dispersible latex is such a one wherein polymer particles are used as a dispersoid and are dispersed in water. For improving the fine image reproducibility, it is necessary to use two kinds or more of the component (A). Examples of the component (A) include specifically: water-dispersible latex polymers, such as polybutadiene latex, natural rubber latex, styrene-butadiene copolymer latex, acrylonitrile-butadiene copolymer latex, polychloroprene latex, polyisoprene latex, polyurethane latex, methylmethacrylate-butadiene copolymer latex, vinylpyridine polymer latex, butyl polymer latex, thiokol polymer latex and acrylate polymer latex; and polymers obtained by copolymerizing another component, such as acrylic acid and methacrylic acid, therewith. Among these, water-dispersible latex polymers having a butadiene skeleton or an isoprene skeleton in molecular chains are preferably used from the viewpoints of hardness and rubber elasticity. More specifically, polybutadiene (BR) latex and acrylonitrile-butadiene copolymer (NBR) latex are preferably used. Compounding amount of the component (A) in the composition is preferred to be 50 to 90% by mass. When it is less than 50% by mass, it is not preferable because strength as a printing plate may become insufficient while, when it is more than 90% by mass, it is not preferable because water developing process may become time-consuming.

The component (B) (rubber) in the present invention is used for imparting rubber elasticity to the photosensitive resin composition. Specific examples of the component (B) include butadiene rubber (BR), nitrile rubber (NBR), acrylic rubber, epichlorohydrin rubber, urethane rubber, isoprene rubber, styrene isoprene rubber, styrene butadiene rubber, ethylene-propylene copolymer and chlorinated polyethylene. Each of them may be used solely or two or more of them may be used jointly. Among them, butadiene rubber (BR) and nitrile rubber (NBR) are preferred. It is also preferred that the hydrophobic polymers obtained from water-dispersible latexes of the above component (A) and the rubber of the component (B) have a common chemical structure unit. As a result thereof, mechanical strength of the photosensitive resin composition is enhanced and a printing plate exhibiting the printing durability can be obtained.

Compounding ratio of the component (A) (hydrophobic polymers obtained from water-dispersible latexes) to the component (B) (rubber) in the photosensitive resin composition needs to be within a range of 1 to 7% in terms of the ratio of the mass of the component (B) to the total mass of the components (A) and (B) (ratio by mass of B/(A + B)). It is preferred to be within a range of 1.5 to 7%, and more preferred to be within a range of 2 to 6%. When the ratio by mass is less than the above range, mechanical strength/elongation lowers. When it exceeds the above range, there is a problem that fine image reproducibility (1% reproducibility of 150 lpi and 175 lpi) becomes insufficient.

The component (C) (photopolymerizable compound) in the present invention is preferred to be a photopolymerizable oligomer. Compounding amount of the component (C) in the composition is preferred to be 1 to 50% by mass. When it is less than 1% by mass, a relief becomes fragile resulting in deterioration of the flexibility. When it is more than 50% by mass, a raw plate becomes too soft and handling property becomes bad whereby it is not preferred.

The component (C) (photopolymerizable compound) in the present invention is preferred to contain a photopolymerizable oligomer and a photopolymerizable monomer. The photopolymerizable oligomer is a polymer having a number average molecular weight of 1,000 to 10,000 which has been obtained by binding an ethylenic unsaturated group to terminal and/or side chain of a conjugated diene-based polymer. The conjugated diene-based polymer which constitutes the conjugated diene-based ethylenic polymer is formed of a homopolymer of a conjugated diene unsaturated compound or a copolymer of a conjugated diene unsaturated compound and a monoethylenically unsaturated compound. Examples of such a copolymer include a butadiene polymer, an isoprene polymer, a chloroprene polymer, a styrene-chloroprene copolymer, an acrylonitrile-butadiene copolymer, an acrylonitrile-isoprene copolymer, a methyl methacrylate-isoprene copolymer, a methyl methacrylate-chloroprene copolymer, a methyl acrylate-butadiene copolymer, a methyl acrylate-isoprene copolymer, a methyl acrylate-chloroprene copolymer, an acrylonitrile-butadiene-styrene copolymer and an acrylonitrile-chloroprene-styrene copolymer. Among these, a butadiene polymer, an isoprene polymer and an acrylonitrile-butadiene copolymer are preferable, and a butadiene polymer and an isoprene polymer are particularly preferable from the viewpoint of rubber elasticity and photocurability.

The photopolymerizable monomer preferably comprises at least one kind of alkyl methacrylate and, particularly preferably, it comprises a C_{8∼18} and straightly linear alkyl methacrylate. Specific examples thereof include alkyl (meth)acrylate such as methyl (meth)acrylate, ethyl (meth)acrylate, propyl (meth)acrylate, butyl (meth)acrylate, isoamyl (meth)acrylate, 2-ethylhexyl (meth)acrylate, lauryl (meth)acrylate or stearyl (meth)acrylate; cycloalkyl (meth)acrylate such as cyclohexyl (meth)acrylate; halogenated alkyl (meth)acrylate such as chloroethyl (meth)acrylate or chloropropyl (meth)acrylate; alkoxyalkyl (meth)acrylate such as methoxyethyl (meth) acrylate, ethoxyethyl (meth) acrylate or butoxyethyl (meth)acrylate; and phenoxyalkyl (meth)acrylate such as phenoxyethyl (meth)acrylate or nonylphenoxyethyl (meth)acrylate. Particularly preferred examples include n-lauryl methacrylate, alkyl (C_{12∼13}) methacrylate, tridecyl methacrylate and alkyl (C_{12∼15}) methacrylate. Content of the alkyl methacrylate as such is preferred to be 1 to 20% by mass. When it is less than 1% by mass, cross-linking density is insufficient and there is a possibility that no good image reproducibility is achieved. When it is more than 20% by mass, a relief becomes fragile and there is a risk of deteriorating the flexibility.

The component (D) (photopolymerization initiator) in the present invention can be any compound as far as it is capable of causing a polymerizable carbon-carbon unsaturated group to polymerize by light irradiation. Among them, a compound which has a function of generating a radical through self decomposition or hydrogen extraction caused by light absorption is used preferably. Specific examples thereof include benzoin alkyl ethers, benzophenones, anthraquinones, benzyls, acetophenones, diacetyls and the like. Compounding amount of the component (D) in the composition is preferred to be 0.1 to 10% by mass. When it is less than 0.1% by mass, starting efficiency decreases and image reproducibility is inferior. When it is more than 10% by mass, sensitivity becomes high and control of the time for exposing to light becomes difficult.

The component (E) (aggregation inhibitor) in the present invention is preferred to be compounded in order to prevent sudden aggregation among latex particles and solid-liquid separation happening upon preparation of a dope and, particularly, after pouring of a hydrophilic polymer. Compounding amount of the component (E) in the composition is preferred to be 0.01 to 10% by mass and more preferred to be 0.1 to 2% by mass. When it is less than 0.01% by mass, it is not sufficient for preventing the sudden aggregation among latex particles and solid-liquid separation after pouring of the hydrophilic polymer and, when it is more than 10% by mass, swelling of a relief by water and alcohol becomes large and it is not preferred.

As to an aggregation inhibitor, a nonionic surfactant is preferred and that having carbon numbers of 12 to 15 and HLB value of near 5 is particularly preferred. To be more specific, as to a hydrophilic group in the molecular structure, there may be exemplified a polyoxyalkylene chain structure such as polyoxyethylene, polyoxymethylene and polyoxypropylene. With regard to the type of a hydrophobic group in the molecular structure, there may be exemplified a nonylphenyl type, a tridecyl alcohol type, a lauryl alcohol type, a secondary alcohol type and an oxy alcohol type. Each of them may be used solely or two or more thereof may be combined and used.

A plasticizer may be added to the photosensitive resin composition of the present invention for a purpose of, for example, imparting the flexibility. Compounding amount of the plasticizer is preferred to be 0.1 to 30% by mass and more preferred to be 5 to 20% by mass. When it is less than 0.1% by mass, an effect of imparting the flexibility to the photosensitive resin composition is little. When it is more than 30% by mass, a problem in terms of the strength of the photosensitive resin composition happens.

As to the plasticizer, there is no particular limitation therefor so far as it exhibits a property of softening the plate material in general although that which has good miscibility with other component is preferred. More preferred ones include a liquid polyene compound and a compound having an ester bond. With regard to a polyene compound which is liquid at room temperature, there exemplified liquid polybutadiene and polyisoprene as well as its maleinated product, epoxylated product, etc. wherein terminal group or side chain thereof has been modified. With regard to a compound having an ester bond, there are exemplified phthalate, phosphate, sebacate, adipate and polyester having a molecular weight of 1000 to 3000.

A thermal polymerization inhibitor (stabilizer) may be added to the photosensitive resin composition of the present invention in view of enhancement of thermostability upon kneading, enhancement of stability upon storage, etc. Its compounding amount is usually 0.001 to 5% by mass. With regard to the thermal polymerization inhibitor, that of a phenol type, a hydroquinone type, a catechol type, etc. may be exemplified.

In the photosensitive resin composition of the present invention, it is possible to appropriately add other components such as ultraviolet absorber, dye, pigment, defoaming agent and fragrance for a purpose of improving various characteristics within such an extent that the effects of the present invention are not disturbed thereby.

In the photosensitive resin composition of the present invention according to the above compounding, it is preferred that hydrophobic polymers obtained from at least two kinds of water-dispersible latexes exist in fine particles. Also, it is preferred that peaks in the particle size distribution thereof are 2 or more, that the particle size ratio of each peak is two times or more and particularly that the lower limit thereof is about three times or more, and more preferably five times or more while the upper limit thereof is 20 times or less, and more preferably 15 times or less. In the meanwhile, the expression reading "exists in fine particle" means that, when shape observation and phase distribution evaluation are carried out using a scanning probe microscope (SPM) for example, the existence as independent fine particles can be confirmed.

Now, the water-developable flexographic printing original plate using the above photosensitive resin composition of the present invention will be illustrated.

The flexographic printing original plate of the present invention has a photosensitive layer comprising the photosensitive resin composition of the present invention. The printing original plate of the present invention may be either a printing original plate of an analog type wherein a negative film is closely attached onto a photosensitive layer in its actual use or a printing original plate of an LAM (Laser ablation mask) type covered by the so-called CTP (Computer to plate) system wherein an infrared ablation layer which can be ablated with chemical ray is closely attached onto the photosensitive layer previously.

A printing original plate of an analog type comprises a laminate wherein photosensitive layer, adhesion preventing layer and protective film are layered in this order on a support. Incidentally, in the actual use of a printing original plate of an analog type, the protective film is peeled off and, onto the disclosed adhesion prevention layer, a negative film wherein the image is previously formed is closely attached.

A printing original plate of an LAM type comprises a laminate wherein photosensitive layer, protective layer, infrared ablation layer and protective film are layered in this order on a support. In the actual use of the printing original plate of an LAM type, the protective film is peeled off whereupon the infrared ablation layer is disclosed. A part of the infrared ablation layer irradiated with infrared laser can be removed. In the meantime, the infrared ablation layer itself also has a function to shield the transmission of ultraviolet ray in a practical level and, when the image is formed thereon, it can act a role as a negative film.

A polyethylene terephthalate film, which has a superior dimension stability, is in particular preferably used as the support. The thickness of the support is set to 50 to 350 µm, preferably, to 100 to 250 µm, from the viewpoints of mechanical properties, shape stability and handling characteristics upon producing a printing plate. Moreover, if necessary, an adhesive may be applied between them in order to improve an adhesive property between the support and a photosensitive layer.

The adhesion prevention layer is not particularly limited so far as it can be removed by an aqueous developer and the layer can be constituted using any of water-soluble and insoluble polymers. Even in the case of a water-insoluble polymer, it can be removed by a physical rubbing using a brush whereby developing becomes possible but, for a purpose of shortening the developing time, a water-soluble polymer is preferred. Examples of the polymer as such include partially saponified polyvinyl acetate, polyvinyl alcohol, water-soluble cellulose derivative (particularly, hydroxypropyl cellulose, hydroxyethyl cellulose, nitrocellulose and cellulose acetate butyrate), polyacrylic acid, polyethylene oxide, soluble alkyl cellulose polyamide, polybutyral, butyl rubber, NBR rubber, acrylic rubber, styrene-butadiene rubber, latex and soluble polyester. With regard to those polymers, it is not limited to the use of one kind thereof but two or more kinds of polymers may be combined and used. In view of water developing ability, prevention of adhesion and image reproducibility, it is particularly preferred to use a partially-saponified polyvinyl acetate having a saponification degree of 60 to 99 molar % and a water-soluble cellulose derivative among the above.

It is preferred that the infrared ablation layer has an optical density of 2.0 or more to chemical ray. The optical density of the infrared ablation layer is more preferred to be 2.2 to 2.5 to chemical ray. Thickness of the infrared ablation layer is preferred to be 0.5 to 5.0 µm and more preferred to be 1.0 to 2. 0 µm. When it is less than 0.5 µm, a high coating technique is needed and there is a possibility that no optical density of more than a predetermined extent can be achieved. When it is more than 5.0 µm, high energy is needed for evaporation of an infrared ablation layer and it is disadvantageous in terms of cost. The infrared ablation layer is constituted from a binder and a material having a function of absorbing the infrared laser followed by converting into heat and a function of shielding the ultraviolet light. Although there is no particular limitation for the binder, it is preferred to use a copolymerized polyamide exhibiting polarity. As to a material having an infrared ray-absorbing function and an ultraviolet light-shielding function, carbon black is particularly preferred in view of light/heat converting rate, economy and handling ability. The material having an infrared ray-absorbing function and an ultraviolet light-shielding function is appropriately used in such a concentration by which the above-mentioned optical density and layer thickness can be achieved and, it is usually 1 to 60% by mass and preferably 10 to 50% by mass to the total mass of the infrared ablation layer. When it is less than 1% by mass, the optical density becomes less than 2.0 and there is a fear that neither infrared ray-absorbing function nor ultraviolet light-shielding function is achieved. When it is more than 60% by mass, other component such as a binder becomes insufficient whereby there is a fear that the film forming ability lowers.

Examples of the protective film include a polyethylene terephthalate film, a polyethylene naphthalate film and a polybutylene terephthalate film. However, such a protective film is not absolutely necessary.

### Examples

The present invention will now be specifically illustrated by way of the following Examples and Comparative Examples although the present invention is not limited thereto.

### Example 1

### Preparation of photosensitive resin composition

BR rubber (Nipol BR1220 manufactured by Nippon Zeon) (1.3 parts by mass) as the component (B) and 80 parts by mass of toluene were heated at 60°C to prepare a liquid in which rubber is dissolved. This was allowed to cool to room temperature and then 76.4 parts by mass of butadiene latex (Nipol LX111NF containing 55% of non-volatile components; manufactured by Nippon Zeon) and 27.9 parts by mass of acrylonitrile-butadiene latex (Nipol SX1503 containing 43% of non-volatile components; manufactured by Nippon Zeon) as the component (A) ; 15 parts by mass of oligobutadiene acrylate (ABU-4S manufactured by Kyoeisha Kagaku), 7.5 parts by mass of lauryl methacrylate (Light Ester L manufactured by Kyoeisha Kagaku) and 7.5 parts by mass of trimethylolpropane triacrylate (Light Ester TMP manufactured by Kyoeisha Kagaku) as the component (C) ; 1 part by mass of a photopolymerization initiator (Irgacure 651) as the component (D) ; 1 part by mass of an aggregation inhibitor (Nonion TA-405 manufactured by Nichiyu KK) as the component (E) ; and 20 parts by mass of a hydrophilic polymer (PFT-3 containing 25% of non-volatile components, manufactured by Kyoeisha Kagaku) and 0.03 part by mass of hydroquinone monomethyl ether as other components were mixed in a container to prepare a dope. The dope was poured into a pressurizing kneader and toluene and water were removed therefrom *in vacuo* at 80°C.

### Manufacture of flexographic printing original plate

Carbon black dispersion (AMBK-8 manufactured by Orient Kagaku Kogyo KK), copolymerized polyamide (PA223 manufactured by TOYOBO CO., LTD.), propylene glycol and methanol were mixed in a ratio of 45/5/5/45 by mass to prepare a coating liquid for infrared ablation layer. After a releasing treatment was applied onto both sides of a PET film (E5000 manufactured by TOYOBO CO., LTD.; thickness: 100 µm), the coating liquid for infrared ablation layer was applied thereto using a bar coater so as to make the thickness of the coat after drying 1.6 µm and then dried at 120°C for 5 minutes to prepare a film laminate (I). Optical density thereof was 2.3. This optical density was measured by a white-and-black transmission densitometer DM-520 (manufactured by Dainippon Screen). Polyvinyl alcohol having low saponification degree (KH20 manufactured by Nippon Gosei), plasticizer (Sanflex SE 270 manufactured by Sanyo Chemical Industries; polyether polyol of an aliphatic polyhydric alcohol type; solid concentration 85%) and NBR latex (SX1503A manufactured by Nippon Zeon; solid concentration 42%) were mixed in a ratio by mass of 50/20/30 to give a coating liquid for a protective layer. The coating liquid for a protective layer was applied onto the film laminate (I) using a bar coated so as to make the thickness of the coat after drying 2.0 µm and dried at 120°C for 5 minutes to prepare a film laminate (II). The above photosensitive resin composition was placed on a PET film support (E5000 manufactured by TOYOBO CO., LTD.; thickness: 125 µm) on which an adhesive of a copolymerized polyester type was applied and a film laminate (II) was layered thereon. The above was laminated at 100°C using a heat press machine to give a flexographic printing original plate comprising PET support, adhesive layer, photosensitive layer, protective layer, infrared ablation layer and protective film. Total thickness of the plate was 1.70 mm.

### Manufacture of printing plate from flexographic printing original plate

Chemical ray (light source: Philips 10R; illumination at 365 nm: 8 mW/cm²) was irradiated for one minute from the PET support side of the printing original plate. After that, the protective film was peeled off therefrom. This plate was wound around Esko CDI SPARK 2530 followed by forming an image. After ablation, the plate was taken out and returned to a flat plane and chemical ray (light source: Philips 10R; illumination at 365 nm: 8 mW/cm²) was irradiated thereon for seven minutes. After that, development was carried out at 40°C for eight minutes using a developing device (Stuck System) manufactured by A&V. Tap water to which 1% of CO-OP powder soap (manufactured by CO-OP) was added was used as a developer. After developing, it was dried at 60°C for ten minutes, chemical ray was irradiated thereon for ten minutes and, finally, a germicidal lamp was irradiated thereon for five minutes for removing the stickiness on the surface.

### Examples 2 to 10 and Comparative Examples 1 to 3

A printing plate was manufactured in the same manner as in Example 1 except that the composition and the compounding ratio of the photosensitive resin composition were made as mentioned in Table 1.

Stability of a dope, mechanical strength/elongation of a photosensitive resin composition and fine image reproducibility of a printing plate were evaluated according to the following evaluation methods.

### (1) Evaluation of stability of dope

State of a dope immediately after the preparation was observed by naked eye before pouring into a kneader.

In case it was uniform, it was evaluated as o. In case aggregation and solid-liquid separation were partially noted, it was evaluated as Δ. In case sudden aggregation and solid-liquid separation were noted, it was evaluated as x.

### (2) Mechanical strength/elongation of the photosensitive resin composition

A photosensitive resin composition subjected to heat pressing to an extent of 1 mm thickness was photo-cured and taken out using a metal mold. Elongation and strength thereof were measured by a tensile test using Tensilon (using 100 kg of cross-head) at a test speed of 200 mm/minute. The measured elongation and strength were multiplied together and the product was adopted as the mechanical strength/elongation (kg%/mm²).

When the resulting data were 200 or more, 150 to less than 200 and less than 150, they were evaluated as ○○, ○ and x, respectively.

### (3) Fine image reproducibility of printing plate

A screen dot reproducibility of the resulting printing plate for 150 lpi 2%, 175 lpi 2%, 150 lpi 1% or 175 lpi 1% was observed through a loupe.

When reproducibility of 95% or more was confirmed, it was evaluated as ○○, when that of 90% to less than 95% was confirmed, it was evaluated as ○ and, when only less than 90% of reproducibility was confirmed, it was evaluated as x.

The compositions (part(s) by mass) of the photosensitive resin compositions and the evaluation results of the printing plates according to Examples 1 to 10 and Comparative Examples 1 to 3 are shown in Table 1.

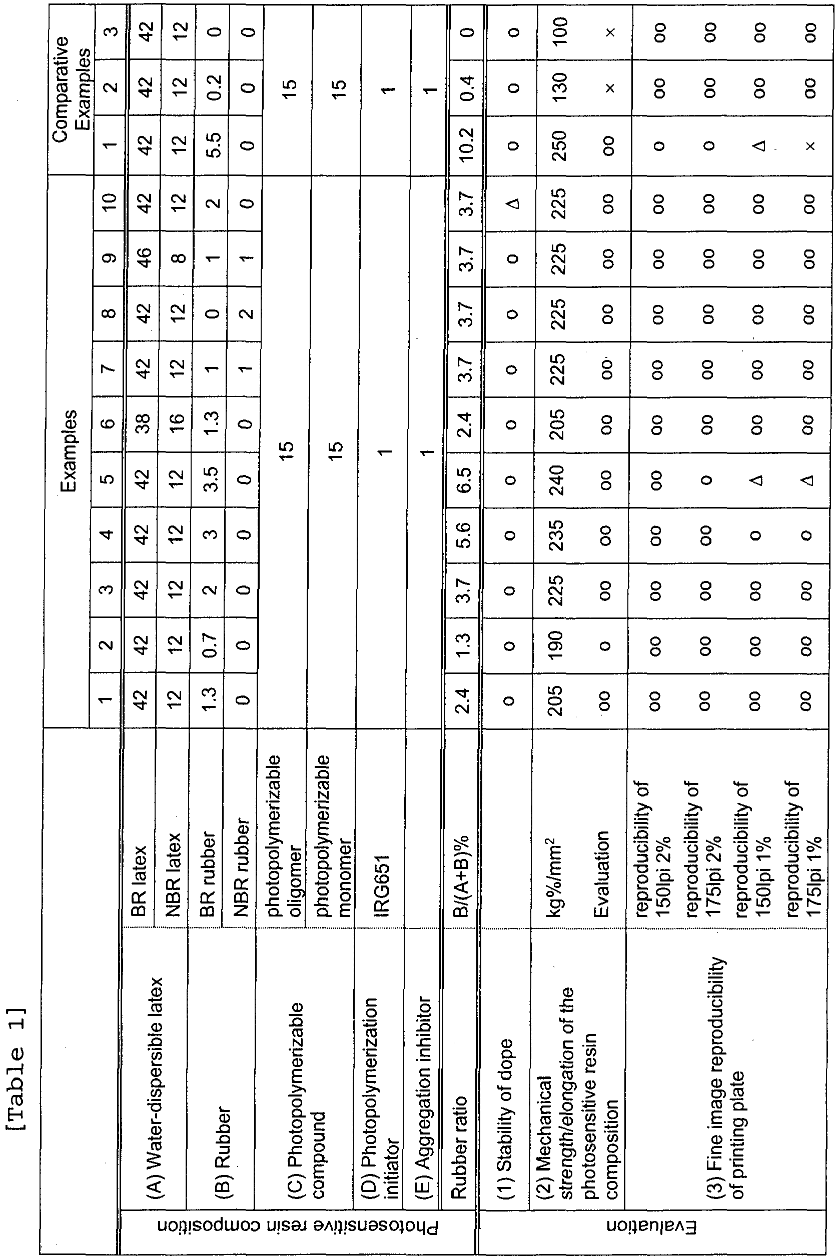

### Industrial Applicability

In accordance with the photosensitive resin composition of the present invention, it is now possible to prepare a water-developable flexographic printing original plate in which both printing durability and fine image reproducibility are highly excellent.

## Claims

1. A photosensitive resin composition for a flexographic printing original plate, **characterized in that**, the composition contains (A) hydrophobic polymers obtained from at least two kinds of water-dispersible latexes, (B) a rubber for imparting rubber elasticity to the photosensitive resin composition, (C) a photopolymerizable compound and (D) a photopolymerization initiator and that the ratio by mass of the component (B) to the total mass of the component (A) and the component (B) is within a range of 1 to 7%.

2. The photosensitive resin composition for a flexographic printing original plate according to claim 1, wherein hydrophobic polymer(s) obtained from at least one kind of water-dispersible latex(es) in the above component (A) and the rubber of the component (B) have a common chemical structure unit.

3. The photosensitive resin composition for a flexographic printing original plate according to claim 1 or 2, wherein it further contains (E) an aggregation inhibitor.

4. A flexographic printing original plate, **characterized in that**, a layer comprising partially saponified polyvinyl acetate having a saponification degree of 60 to 99 molar % is formed on the surface of a photosensitive layer comprising the photosensitive resin composition mentioned in any of claims 1 to 3.

5. A flexographic printing original plate, **characterized in that**, a layer comprising a water-soluble cellulose derivative is formed on the surface of a photosensitive layer comprising the photosensitive resin composition mentioned in any of claims 1 to 3.

6. A flexographic printing original plate, **characterized in that**, an infrared ablation layer is formed on the surface of a photosensitive layer comprising the photosensitive resin composition mentioned in any of claims 1 to 3.

## Patentansprüche

1. Photosensitive Harzzusammensetzung für eine Flexodruckoriginalplatte, **dadurch gekennzeichnet, dass** die Zusammensetzung hydrophobe Polymere (A), erhalten aus mindestens zwei Arten von wasserdispergierbaren Latizes, einen Gummi (B) zum Übertragen von Gummielastizität auf die photosensitive Harzzusammensetzung, eine photopolymerisierbare Verbindung (C) und einen Photopolymerisationsinitiator (D) enthält und dass das Verhältnis aus Masse der Komponente (B) zu der Gesamtmasse der Komponente (A) und der Komponente (B) in einem Bereich von 1 bis 7% liegt.

2. Photosensitive Harzzusammensetzung für eine Flexodruckoriginalplatte nach Anspruch 1, wobei hydrophobes Polymer/hydrophobe Polymere, erhalten aus mindestens einer Art von wasserdispergierbarem Latex/wasser-dispergierbaren Latizes, in der vorstehenden Komponente (A) und der Gummi der Komponente (B) eine gemeinsame chemische Struktureinheit aufweisen.

3. Photosensitive Harzzusammensetzung für eine Flexodruckoriginalplatte nach Anspruch 1 oder 2, wobei sie weiter einen Aggregationsinhibitor (E) enthält.

4. Flexodruckoriginalplatte, **dadurch gekennzeichnet, dass** eine Schicht, umfassend teilweise verseiftes Polyvinylacetat mit einem Verseifungsgrad von 60 bis 99 mol%, auf der Oberfläche einer photosensitiven Schicht, umfassend die photosensitive Harzzusammensetzung nach einem der Ansprüche 1 bis 3, gebildet ist.

5. Flexodruckoriginalplatte, **dadurch gekennzeichnet, dass** eine Schicht, umfassend ein wasserlösliches Zellulosederivat, auf der Oberfläche einer photosensitiven Schicht, umfassend die photosensitive Harzzusammensetzung nach einem der Ansprüche 1 bis 3, gebildet ist.

6. Flexodruckoriginalplatte, **dadurch gekennzeichnet, dass** eine InfrarotAblationsschicht auf der Oberfläche einer photosensitiven Schicht, umfassend die photosensitive Harzzusammensetzung nach einem der Ansprüche 1 bis 3, gebildet ist.

## Revendications

1. Composition de résine photosensible pour une plaque originale d'impression flexographique, **caractérisée en ce que** la composition contient (A) des polymères hydrophobes obtenus à partir d'au moins deux types de latex dispersibles dans l'eau, (B) un caoutchouc pour donner une élasticité de caoutchouc à la composition de résine photosensible, (C) un composé photopolymérisable et (D) un initiateur de photopolymérisation et **en ce que** le rapport en masse du composant (B) à la masse totale du composant (A) se situe dans une plage de 1 à 7 %.

2. Composition de résine photosensible pour une plaque originale d'impression flexographique selon la revendication 1, dans laquelle le(les) polymère(s) hydrophobe(s) obtenu(s) à partir d'au moins un type de latex dispersible dans l'eau dans le composant (A) ci-dessus et le caoutchouc du composant (B) ont un motif structural chimique commun.

3. Composition de résine photosensible pour une plaque originale d'impression flexographique selon la revendication 1 ou 2, contenant en outre (E) un inhibiteur d'agrégation.

4. Plaque originale d'impression flexographhique, **caractérisée en ce qu'**une couche comprenant de l'acétate de polyvinyle partiellement saponifié ayant un degré de saponification de 60 à 99 % molaire est formée sur la surface d'une couche photosensible comprenant la composition de résine photosensible mentionnée dans l'une quelconque des revendications 1 à 3.

5. Plaque originale d'impression flexographhique, **caractérisée en ce qu'**une couche comprenant un dérivé de cellulose hydrosoluble est formée sur la surface d'une couche photosensible comprenant la composition de résine photosensible mentionnée dans l'une quelconque des revendications 1 à 3.

6. Plaque originale d'impression flexographique, **caractérisée en ce qu'**une couche d'ablation aux infrarouges est formée sur la surface d'une couche photosensible comprenant la composition de résine photosensible mentionnée dans l'une quelconque des revendications 1 à 3.
